# EUROPEAN PATENT APPLICATION

(11) **EP 4 852 626 A1**
(43) Date of publication of application: **09.12.2026**
(21) Application number: 25814970.7
(22) Date of filing: 10.04.2025
(51) Int. Cl.: H05K 3/46, H01L 23/12, H05K 1/02

(54) **BUILT-IN SUBSTRATE**

(30) Priority: 30.05.2024 JP 2024087677; 11.09.2024 JP 2024157316
(71) Applicant: AISIN CORPORATION, Kariya-shi, Aichi 448-8650 (JP)
(72) Inventor: MUTSUURA, Keita, Kariya-shi, Aichi 448-8650 (JP); EZAKA, Soichiro, Kariya-shi, Aichi 448-8650 (JP); NITTA, Maiko, Kariya-shi, Aichi 448-8650 (JP); HOTTA, Yutaka, Kariya-shi, Aichi 448-8650 (JP)
(74) Representative: Kramer Barske Schmidtchen Patentanwälte PartG mbB
(86) International application number: PCT/JP2025/014329
(87) International publication number: WO 2025/248992

(57) **Abstract**

A built-in substrate (1) in which a plurality of conductive layers (CL) are stacked with insulating layers (IL) interposed therebetween and a power device (SWH, SWL) is incorporated on a center side in a stacking direction (Z), the built-in substrate including a first conductive layer (CL1) on one side in the stacking direction (Z) among the plurality of the conductive layers (CL), the first conductive layer having a first surface (CL1A) on which an electronic component different from the power device (SWH, SWL) is mounted, a second conductive layer (CL6) on the other end side in the stacking direction (Z) among the plurality of the conductive layers (CL), the second conductive layer having a second surface (CL6A) used as a heat dissipation surface that dissipates heat from the power device (SWH, SWL), and a third conductive layer (CL5) in which a conductor pattern (5P1, 5P2) through which a current supplied to the power device (SWH, SWL) flows and that is insulated from the second conductive layer (CL6) is formed, and which is provided between the power device (SWH, SWL) and the second conductive layer (CL6) so as to face the second conductive layer (CL6).

## Description

### TECHNICAL FIELD

The present disclosure relates to a built-in substrate in which a power device is incorporated.

### BACKGROUND ART

In recent years, built-in substrates in which electrical components are embedded in inner layers of substrates have been used. As a technology relating to such a built-in substrate, for example, there has been a technology described in Patent Literature 1 listed below.

Patent Literature 1 describes a semiconductor device in which an electrical component is incorporated in a circuit board. In this semiconductor device, an electrical component is incorporated in a substrate body, a surface electrical component is mounted on a first surface, and a surface conductor pattern is provided on a second surface. A first internal conductor pattern and a second internal conductor pattern insulated from each other are provided between the electrical component and the second surface, the electrical component and the first internal conductor pattern are connected by a first heat transfer via, and the surface conductor pattern and the second internal conductor pattern are connected by a second heat transfer via.

### CITATION LIST

### PATENT LITERATURE

Patent Literature 1: JP 2022-154932 A

### SUMMARY OF INVENTION

### TECHNICAL PROBLEMS

In the semiconductor device described in Patent Literature 1, heat from the electrical component is transferred to the surface conductor pattern via the first heat transfer via, the first internal conductor pattern, the second internal conductor pattern, and the second heat transfer via, and is dissipated to the outside. Here, when the electrical component is energized, Joule heat of not only the electrical component but also a wiring line (conductor) through which current is supplied to the electrical component increases depending on a current value of a flowing current. In the semiconductor device described in Patent Literature 1, the first heat transfer via and the second heat transfer via used for the heat dissipation described above are not provided in a conductive layer through which a current that energizes the electrical component flows. For this reason, efficient dissipation of Joule heat in the conductive layer has not been assumed, and room for improvement remains.

Accordingly, a built-in substrate that enables efficient heat dissipation from a conductive layer is desired.

### SOLUTION TO PROBLEMS

A characteristic configuration of a built-in substrate according to the present disclosure is a built-in substrate in which a plurality of conductive layers are stacked with insulating layers interposed therebetween and a power device is incorporated on a center side in a stacking direction, and the built-in substrate includes a first conductive layer on one side in the stacking direction among the plurality of the conductive layers, the first conductive layer having a first surface on which an electronic component different from the power device is mounted, a second conductive layer on the other end side in the stacking direction among the plurality of the conductive layers, the second conductive layer having a second surface used as a heat dissipation surface that dissipates heat from the power device, and a third conductive layer in which a conductor pattern through which a current supplied to the power device flows and that is insulated from the second conductive layer is formed, and which is provided between the power device and the second conductive layer so as to face the second conductive layer.

With such a characteristic configuration, the conductor pattern of the third conductive layer, through which the current supplied to the power device flows, generates heat depending on the magnitude of the current. Further, the power device also generates heat due to energization. According to the present configuration, since the conductor pattern is provided to face the second conductive layer having the second surface used as the heat dissipation surface, heat of each of the power device and the third conductive layer including the conductor pattern can be efficiently dissipated via the second surface.

### BRIEF DESCRIPTION OF DRAWINGS

FIG. 1 is an example of a circuit diagram formed in a built-in substrate of a first embodiment.
FIG. 2 is an image diagram showing a cross section of the built-in substrate of the first embodiment.
FIG. 3 is a plan view of a first layer of a conductive layer of the first embodiment.
FIG. 4 is a plan view of a second layer of the conductive layer of the first embodiment.
FIG. 5 is a plan view of a third layer of the conductive layer of the first embodiment.
FIG. 6 is a plan view of a fourth layer of the conductive layer of the first embodiment.
FIG. 7 is a plan view of a fifth layer of the conductive layer of the first embodiment.
FIG. 8 is a plan view of a sixth layer of the conductive layer of the first embodiment.
FIG. 9 is a plan view of a second layer of a conductive layer of a modified example of the first embodiment.
FIG. 10 is a plan view of a fifth layer of the conductive layer of the modified example of the first embodiment.
FIG. 11 is a circuit diagram configured by a power device incorporated in a built-in substrate of a second embodiment.
FIG. 12 is an image diagram showing a cross section of the built-in substrate of the second embodiment.
FIG. 13 is a plan view of a first layer of a conductive layer of the second embodiment.
FIG. 14 is a plan view of a second layer of the conductive layer of the second embodiment.
FIG. 15 is a plan view of a third layer of the conductive layer of the second embodiment.
FIG. 16 is a plan view of a fourth layer of the conductive layer of the second embodiment.
FIG. 17 is a plan view of a fifth layer of the conductive layer of the second embodiment.
FIG. 18 is a plan view of a sixth layer of the conductive layer of the second embodiment.
FIG. 19 is a diagram showing a first region and a second region of the second embodiment.

### DESCRIPTION OF EMBODIMENTS

### 1. First Embodiment

A built-in substrate according to the present disclosure is configured to appropriately dissipate heat generated in a power device incorporated in the built-in substrate and a pattern formed in the built-in substrate. A built-in substrate 1 of the present embodiment will be described below. However, the built-in substrate 1 is not limited to the following embodiment and may be modified in various ways without departing from the gist of the built-in substrate 1.

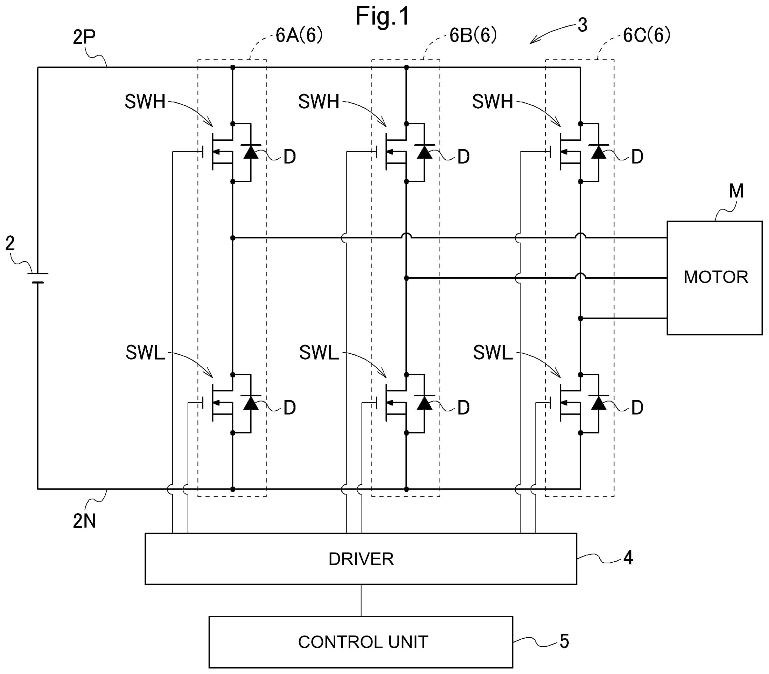

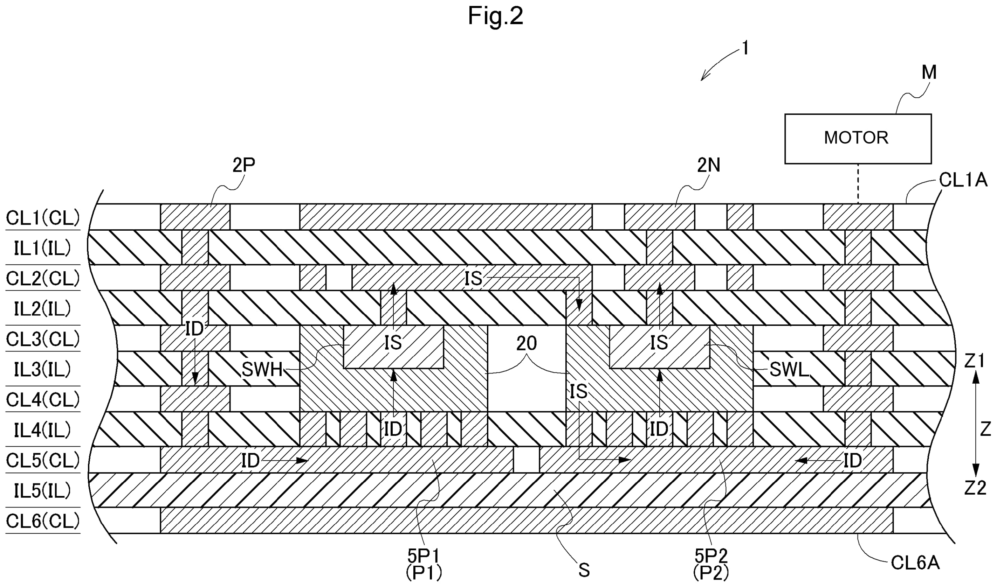

FIG. 1 is a circuit diagram of a circuit partially formed in the built-in substrate 1 (see FIG. 2) of the present embodiment. FIG. 1 shows an inverter 3 that converts DC power from a battery 2 into AC power and drives a motor M (an example of "load"). A three-phase motor is used as the motor M. For this reason, the inverter 3 includes three legs 6 (hereinafter referred to as legs 6A, 6B, and 6C), each including a high-side switching element SWH (an example of "power device") and a low-side switching element SWL (an example of "power device") connected in series to each other. For example, n-type metal-oxide-semiconductor field-effect transistors (MOS-FETs) are used as these switching elements SWH and SWL.

The three legs 6A, 6B, and 6C are connected in parallel with each other to a power supply line 2P connected to a positive electrode of the battery 2 and a power supply line 2N connected to a negative electrode of the battery 2. In each of the legs 6A, 6B, and 6C, a drain terminal of the switching element SWH is connected to the power supply line 2P, and a source terminal of the switching element SWL is connected to the power supply line 2N. The source terminal of the switching element SWH and the drain terminal of the switching element SWL are connected to each other. In each of the switching element SWH and the switching element SWL, a diode D is provided across the source terminal and the drain terminal. The source terminal of the switching element SWH of each of the plurality of legs 6A, 6B, and 6C is connected to a terminal of the motor M.

The gate terminal of each of the switching element SWH and the switching element SWL is connected to a control unit 5 via a driver 4. Accordingly, the inverter 3 converts the DC power from the battery 2 into three-phase AC power by sequentially switching a state in which the high-side switching element SWH of a predetermined one of the three legs and the low-side switching element SWL of one of the remaining two legs are brought into a closed state and other switching elements are brought into an open state. The motor M is driven by supplying such three-phase AC power to the motor M.

As shown in FIG. 2, in the built-in substrate 1, a plurality (six in the present embodiment) of conductive layers CL are stacked with insulating layers IL interposed therebetween. In the following, the six conductive layers CL are referred to as a conductive layer CL1, a conductive layer CL2, a conductive layer CL3, a conductive layer CL4, a conductive layer CL5, and a conductive layer CL6, and it is assumed that the conductive layer CL1, the conductive layer CL2, the conductive layer CL3, the conductive layer CL4, the conductive layer CL5, and the conductive layer CL6 are stacked in this order from the top. In addition, an insulating layer IL1 is interposed between the conductive layer CL1 and the conductive layer CL2, an insulating layer IL2 is interposed between the conductive layer CL2 and the conductive layer CL3, an insulating layer IL3 is interposed between the conductive layer CL3 and the conductive layer CL4, an insulating layer IL4 is interposed between the conductive layer CL4 and the conductive layer CL5, and an insulating layer IL5 is interposed between the conductive layer CL5 and the conductive layer CL6.

Here, the direction in which the six conductive layers CL are stacked is defined as a stacking direction Z. As shown in FIG. 2, in the built-in substrate 1, the switching elements SWH and SWL included in a predetermined leg 6 are incorporated in a central portion in the stacking direction Z. In the stacking direction Z, the conductive layer CL1 side as viewed from the switching elements SWH and SWL is defined as a stacking direction Z1 side, and the conductive layer CL6 side as viewed from the switching elements SWH and SWL is defined as a stacking direction Z2 side.

The conductive layer CL1 corresponds to a first conductive layer on one side (stacking direction Z1 side) in the stacking direction Z. The conductive layer CL6 corresponds to a second conductive layer on another end side (stacking direction Z2 side) in the stacking direction Z. In addition, as described in detail later, the conductive layer CL5 corresponds to a third conductive layer.

In the present embodiment, one built-in substrate 1 is provided with the switching element SWH and the switching element SWL of one leg 6 among the three legs 6A, 6B, and 6C described above. In addition, in one built-in substrate 1, three switching elements SWH are provided to be connected in parallel with each other, and three switching elements SWL are provided to be connected in parallel with each other.

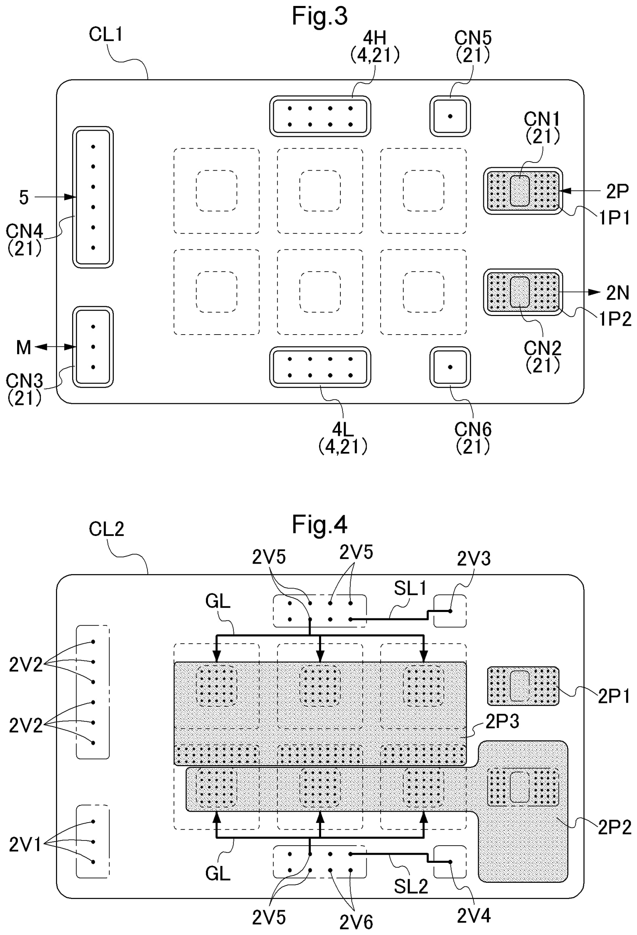

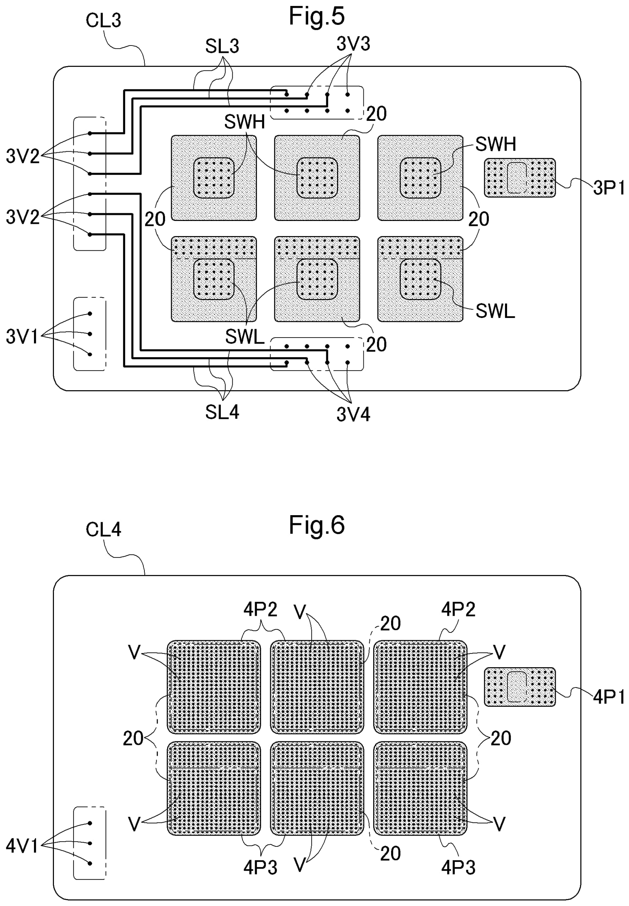

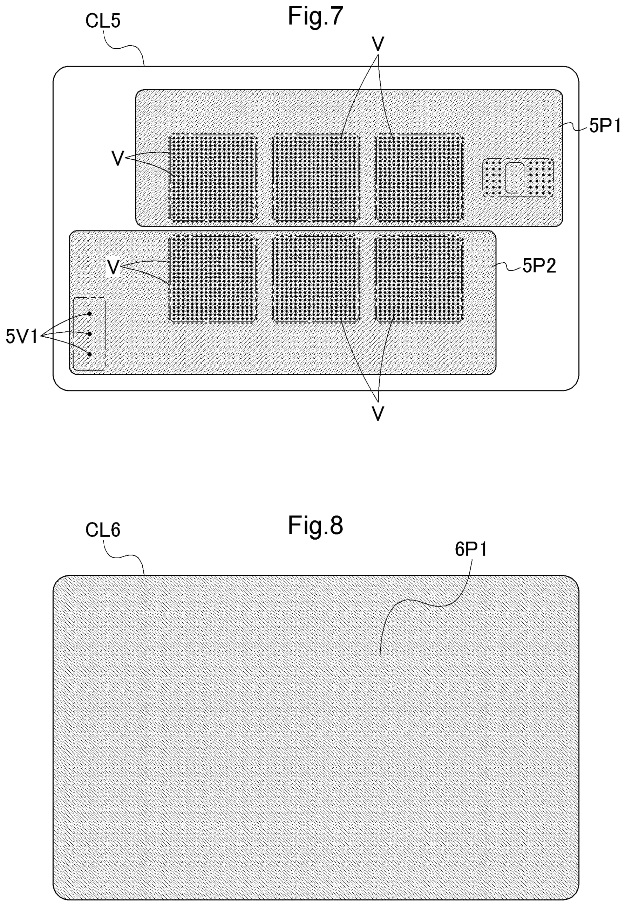

FIG. 3 shows a plan view of the conductive layer CL1, FIG. 4 shows a plan view of the conductive layer CL2, and FIG. 5 shows a plan view of the conductive layer CL3. Furthermore, FIG. 6 shows a plan view of the conductive layer CL4, FIG. 7 shows a plan view of the conductive layer CL5, and FIG. 8 shows a plan view of the conductive layer CL6.

As shown in FIG. 3, on the conductive layer CL1, a connector CN1 to which the power supply line 2P is connected, a connector CN2 to which the power supply line 2N is connected, a connector CN3 to which the motor M is connected, a connector CN4 that inputs, to the driver 4 (drivers 4H and 4L described later), control signals transmitted from the control unit 5 to the switching elements SWH and SWL, a connector CN5 that supplies power to the driver 4H, a connector CN6 that supplies power to the driver 4L, a driver 4H for driving the switching element SWH, and a driver 4L for driving the switching element SWL are mounted. Therefore, an electronic component 21 different from the switching element SWH and the switching element SWL is mounted on a first surface CL1A of the conductive layer CL1 on the stacking direction Z1 side. The electronic component 21 may be, for example, a capacitor or a resistor. Note that, in the present embodiment, "connect" means "connect in a state in which current flows". Furthermore, in the present embodiment, the first surface CL1A is a mounting surface on one end side (stacking direction Z1 side) in the stacking direction Z.

As shown in FIG. 4, the conductive layer CL2 includes a pattern 2P1 connected through a via to a land 1P1 on which the connector CN1 of the conductive layer CL1 is mounted, a pattern 2P2 connected through a via to a land 1P2 on which the connector CN2 of the conductive layer CL1 is mounted, a via 2V1 connected to a terminal of the connector CN3 of the conductive layer CL1, a via 2V2 connected to a terminal of the connector CN4 of the conductive layer CL1, a via 2V3 connected to a terminal of the connector CN5 of the conductive layer CL1, and a via 2V4 connected to a terminal of the connector CN6 of the conductive layer CL1. In addition, a pattern 2P3 that connects the source terminal of the switching element SWH and the drain terminal of the switching element SWL is included. Further included are a via 2V5 connected to a terminal of the driver 4H of the conductive layer CL1, a via 2V6 connected to a terminal of the driver 4L of the conductive layer CL1, a signal line SL1 connecting the via 2V3 and the via 2V5, a signal line SL2 connecting the via 2V4 and the via 2V6, and a wiring line GL connecting gate terminals of the switching elements SWH and SWL to the respective vias 2V5 and 2V6. Note that, regarding the wiring line GL, although a gate terminal side is indicated by arrows, the wiring line GL is actually connected to the gate terminals.

In the built-in substrate 1, the switching element SWH and the switching element SWL are incorporated on the central side in the stacking direction Z. In the present embodiment, the switching element SWH and the switching element SWL are each placed on a base member 20. The base member 20 of the present embodiment is formed by, for example, a rectangular columnar body or a plate-shaped body. As shown in FIGS. 5 and 6, the base member 20, the switching element SWH, and the switching element SWL are provided across the conductive layer CL3 and the conductive layer CL4.

In addition, as shown in FIG. 5, the conductive layer CL3 includes a pattern 3P1 connected through a via to the pattern 2P1 of the conductive layer CL2, a via 3V1 connected to the via 2V1 of the conductive layer CL2, a via 3V2 connected to 2V2 of the conductive layer CL2, a via 3V3 connected to the via 2V5 of the conductive layer CL2, and a via 3V4 connected to 2V6 of the conductive layer CL2. Furthermore, a signal line SL3 connecting the via 3V2 and the via 3V3 of the conductive layer CL3, and a signal line SL4 connecting the via 3V2 and the via 3V4 of the conductive layer CL3 are included.

As shown in FIG. 6, the conductive layer CL4 includes a pattern 4P1 connected through a via to the pattern 3P1 of the conductive layer CL3, and a via 4V1 connected to the via 3V1 of the conductive layer CL3. Furthermore, a pattern 4P2 connected to a bottom surface of the base member 20 on which the switching element SWH is placed, and a pattern 4P3 connected to a bottom surface of the base member 20 on which the switching element SWL is placed are included.

As shown in FIG. 7, the conductive layer CL5 includes a conductor pattern 5P1 connected through a via to the pattern 4P1 of the conductive layer CL4 and the pattern 4P2 to which the drain terminal of the switching element SWH is connected, and a conductor pattern 5P2 connected through a via to the pattern 4P3 of the conductive layer CL4, to which the drain terminal of the switching element SWL is connected, and connected to a via 5V1 connected to the via 4V1 of the conductive layer CL4.

As shown in FIG. 8, the conductive layer CL6 includes a pattern 6P1 insulated from each of the conductive layers CL1 to CL5 and formed over the entire surface. This pattern 6P1 is connected to, for example, a housing of the inverter 3 through a harness or a screw.

Note that, although not shown, the conductive layers CL1 to CL5 are preferably provided with grounded patterns at portions different from the respective patterns and wiring lines described above.

A second surface CL6A of the conductive layer CL6 on the stacking direction Z2 side is used as a heat dissipation surface that dissipates heat from the switching elements SWH and SWL. Here, the switching elements SWH and SWL generate heat in response to energization. This heat reaches the conductive layer CL6 through the conductive layer CL5 and the insulating layer IL5, and is dissipated from the conductive layer CL6. The insulating layer IL5 is preferably formed using a material S (see FIG. 2) having high thermal conductivity in order to efficiently transfer heat from the conductive layer CL5 to the conductive layer CL6. That is, among the plurality of insulating layers IL, the insulating layer IL5 between the conductive layer CL6 and the conductive layer CL5 is preferably formed using a material having a higher thermal conductivity than those of the other insulating layers IL1, IL2, IL3, and IL4.

As described above, the conductive layer CL5 includes the conductive pattern 5P1 connected through a via to the drain terminal of the switching element SWH, and the conductive pattern 5P2 connected through a via to the drain terminal of the switching element SWL. Therefore, the conductive layer CL5 is formed with the conductor patterns 5P1 and 5P2 through which a current supplied to the switching elements SWH and SWL flows and which are insulated from the conductive layer CL6, and is provided between the switching elements SWH and SWL and the conductive layer CL6 so as to face the conductive layer CL6. The current supplied to the switching elements SWH and SWL means a current flowing into the switching elements SWH and SWL. That is, in the switching element SWH, the current corresponds to a current flowing from the battery 2 via the power supply line 2P, and in the switching element SWL, the current corresponds to a current flowing from the motor M. Therefore, in the conductive layer CL5, the conductor pattern 5P1 through which a current supplied to the switching element SWH flows and which is insulated from the conductive layer CL6, and the conductor pattern 5P2 through which a current supplied to the switching element SWL flows and which is insulated from the conductive layer CL6 are formed. Furthermore, both the conductor pattern 5P1 and the conductor pattern 5P2 are insulated from the conductive layer CL6.

In the present embodiment, when the switching elements SWH and SWL and the conductive layer CL5 are viewed along the stacking direction Z, mounting regions of the switching elements SWH and SWL are included in the conductor patterns 5P1 and 5P2. "When the switching elements SWH and SWL and the conductive layer CL5 are viewed along the stacking direction Z" means that the conductive layer CL4, on which the base members 20 on which the switching elements SWH and SWL are placed are provided, and the conductive layer CL5 are viewed along the stacking direction Z. The mounting regions of the switching elements SWH and SWL are not limited to regions in which the switching elements SWH and SWL are provided, and are regions in which the base members 20 on which the switching elements SWH and SWL are placed are mounted. Therefore, as shown in FIGS. 6 and 7, when the conductive layer CL4, on which the base members 20 on which the switching elements SWH and SWL are placed are provided, and the conductive layer CL5 are viewed along the stacking direction Z, the regions in which the base members 20 on which the switching elements SWH and SWL are placed are mounted are configured to be included in the conductor patterns 5P1 and 5P2 in the conductive layer CL5. That is, when the conductive layer CL4 and the conductive layer CL5 are viewed along the stacking direction Z, the region in which the base member 20 on which the switching element SWH is placed is mounted is included in the conductor pattern 5P1 in the conductive layer CL5, and the region in which the base member 20 on which the switching element SWL is placed is mounted is included in the conductor pattern 5P2 in the conductive layer CL5. As a result, heat from the switching element SWH is easily transferred to the conductor pattern 5P1, and heat from the switching element SWL is easily transferred to the conductor pattern 5P2. Therefore, heat from the switching element SWH and the switching element SWL can be transferred to the conductive layer CL6 via the conductor pattern 5P1 and the conductor pattern 5P2 and dissipated.

Furthermore, in the present embodiment, the switching elements SWH and SWL and the conductor patterns 5P1 and 5P2 are electrically connected through the vias V provided over the entire mounting regions of the switching elements SWH and SWL. That is, in the regions in which the respective base members 20 on which the switching elements SWH and SWL are placed are mounted, vias connected to the conductor patterns 5P1 and 5P2 of the conductive layer CL5 are formed over the entire surfaces. Therefore, resistance between each of the switching elements SWH and SWL and each of the conductor patterns 5P1 and 5P2 of the conductive layer CL5 can be reduced, so that the amount of heat generated between the conductive layer CL4 and the conductive layer CL5 can be reduced.

As described above, on the first surface CL1A, a plurality of electrodes electrically connected to each of the battery 2 that supplies power to the switching elements SWH and SWL and the motor M energized via the switching elements SWH and SWL are provided, and the plurality of electrodes are electrically connected to the conductor patterns 5P1 and 5P2. As a result, a relatively large current flows through the conductor patterns 5P1 and 5P2, and the conductor patterns 5P1 and 5P2 generate heat due to Joule heat, but heat generated in the conductor patterns 5P1 and 5P2 can be dissipated via the conductive layer CL5.

Next, currents in the built-in substrate 1, in particular, flows of source currents and drain currents of the switching elements SWH and SWL, will be described. As shown in FIG. 2, the power supply line 2P is formed in the conductive layer CL1. The power supply line 2P is electrically connected to the conductive layer CL2 via a via provided in the insulating layer IL1, the conductive layer CL2 is electrically connected to the conductive layer CL3 via a via provided in the insulating layer IL2, the conductive layer CL3 is electrically connected to the conductive layer CL4 via a via provided in the insulating layer IL3, and the conductive layer CL4 is electrically connected to the conductor pattern P1 (conductor pattern 5P1) of the conductive layer CL5 via a via provided in the insulating layer IL4. The conductor pattern P1 is electrically connected to the drain terminal of the switching element SWH via a via provided in the insulating layer IL4 and the base member 20. Therefore, a drain current ID of the switching element SWH flows from the power supply line 2P through the conductor pattern P1 via the respective conductive layers CL and vias.

The source terminal of the switching element SWH is electrically connected to the conductive layer CL2 via a via provided in the insulating layer IL2, and the conductive layer CL2 is electrically connected to the conductor pattern P2 (conductor pattern 5P2) via a via provided in the insulating layer IL2, the base member 20 of the switching element SWL, and a via provided in the insulating layer IL4. Therefore, a source current IS of the switching element SWH flows from the source terminal of the switching element SWH to the conductor pattern P2 via the via provided in the insulating layer IL2, the base member 20 of the switching element SWL, and the via provided in the insulating layer IL4.

Furthermore, the conductor pattern P2 is electrically connected to the conductive layer CL4 via a via provided in the insulating layer IL4, the conductive layer CL4 is electrically connected to the conductive layer CL3 via a via provided in the insulating layer IL3, the conductive layer CL3 is electrically connected to the conductive layer CL2 via a via provided in the insulating layer IL2, and the conductive layer CL2 is electrically connected to the conductive layer CL1 via a via provided in the insulating layer IL1. The conductive layer CL1 is electrically connected to a terminal of the motor M. Therefore, the source current IS of the switching element SWH temporarily flows from the conductive layer CL2 to the conductive layer CL5, and further flows to the conductive layer CL1. In addition, a current from the motor M flows from the conductive layer CL1 to the conductor pattern P2 via the respective conductive layers and vias (corresponding to a drain current ID of the switching element SWL).

The conductor pattern P2 is electrically connected to the drain terminal of the switching element SWL via the base member 20, and the source terminal of the switching element SWL is electrically connected to the conductive layer CL2 via a via provided in the insulating layer IL2 and is further electrically connected to the power supply line 2N provided in the conductive layer CL1 via a via provided in the insulating layer IL1. Therefore, a source current IS of the switching element SWL flows from the source terminal of the switching element SWL to the power supply line 2N via the via provided in the insulating layer IL2, the conductive layer CL2, and the via provided in the insulating layer IL1.

### 2. Modified Example of First Embodiment

Next, a modified example of the built-in substrate 1 will be described.

In the first embodiment described above, the description has been made assuming that, when the switching elements SWH and SWL and the conductive layer CL5 are viewed along the stacking direction Z, the mounting regions of the switching elements SWH and SWL are included in the conductor patterns 5P1 and 5P2. However, when the switching elements SWH and SWL and the conductive layer CL5 are viewed along the stacking direction Z, the mounting regions of the switching elements SWH and SWL may have a region not included in the conductor patterns 5P1 and 5P2.

In the first embodiment described above, the description has been made assuming that the switching elements SWH and SWL and the conductor patterns 5P1 and 5P2 are electrically connected through the vias V provided over the entire mounting regions of the switching elements SWH and SWL. However, the switching elements SWH and SWL and the conductor patterns 5P1 and 5P2 may be electrically connected through vias V provided in part of the mounting regions of the switching elements SWH and SWL.

In the first embodiment described above, the description has been made assuming that, on the first surface CL1A, the plurality of electrodes electrically connected to each of the battery 2 that supplies power to the switching elements SWH and SWL and the motor M energized via the switching elements SWH and SWL are provided, and the plurality of electrodes are electrically connected to the conductor patterns 5P1 and 5P2. However, the plurality of electrodes can also be configured to be electrically connected to the switching elements SWH and SWL without passing through the conductor patterns 5P1 and 5P2.

In the first embodiment described above, the power devices have been described with the switching elements SWH and SWL as examples, but the power device provided in the built-in substrate 1 may be a single switching element rather than a plurality of switching elements. In addition, the power device need not be an n-type metal-oxide-semiconductor field-effect transistor (MOS-FET), and may be a p-type MOS-FET, may be an insulated gate bipolar transistor (IGBT), or may be a bipolar transistor. Furthermore, the power device need not be the switching elements SWH and SWL, and may be, for example, a load switch or another component that generates heat in response to energization.

In the first embodiment described above, the motor M has been described as an example of the load. However, the load need not be the motor M.

Note that the conductor patterns of the respective conductive layers CL1 to CL6 described in the first embodiment described above are examples and may be changed.

In the first embodiment described above, an example in which the driver 4 is mounted on the built-in substrate 1 has been described. However, the driver 4 may be provided on a substrate different from the built-in substrate 1.

In the first embodiment described above, an example has been described in which the built-in substrate 1 is provided with three switching elements SWH connected in parallel with each other and three switching elements SWL connected in parallel with each other, the switching elements SWH and SWL being included in one leg 6 among the three legs 6. However, the switching elements SWH and the switching elements SWL of the three legs 6 may be provided in the built-in substrate 1.

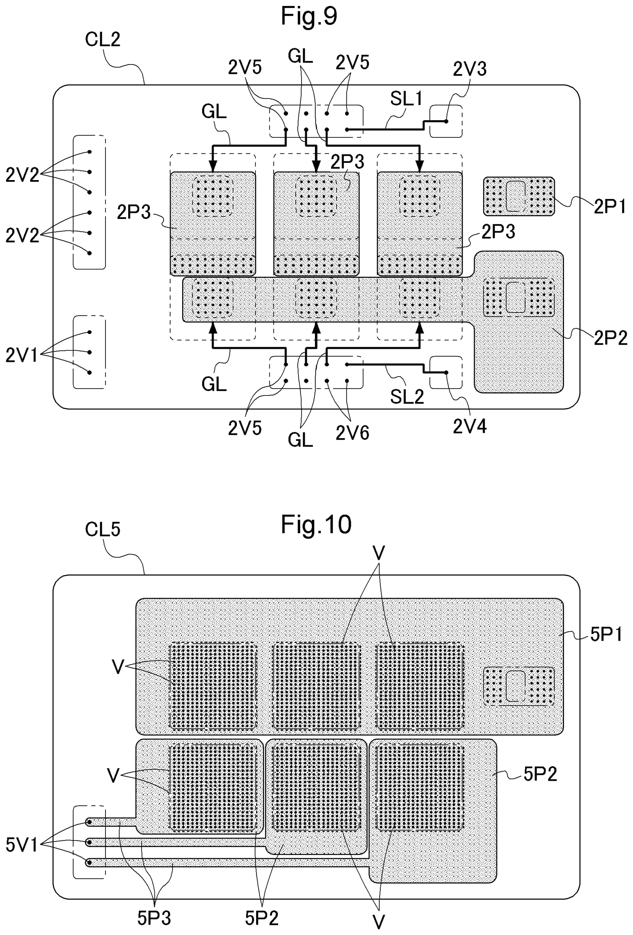

FIG. 9 shows a plan view of the conductive layer CL2 of such a built-in substrate 1, and FIG. 10 shows a plan view of the conductive layer CL5. Description of the other conductive layers is omitted because the other conductive layers are the same as in the first embodiment described above. Note that FIGS. 9 and 10 illustrate an example in which each of the three legs 6 includes one switching element SWH and one switching element SWL.

As shown in FIG. 9, the conductive layer CL2 includes a pattern 2P1 connected through a via to a land 1P1 on which the connector CN1 of the conductive layer CL1 is mounted, a pattern 2P2 connected through a via to a land 1P2 on which the connector CN2 of the conductive layer CL1 is mounted, a via 2V1 connected to a terminal of the connector CN3 of the conductive layer CL1, a via 2V2 connected to a terminal of the connector CN4 of the conductive layer CL1, a via 2V3 connected to a terminal of the connector CN5 of the conductive layer CL1, and a via 2V4 connected to a terminal of the connector CN6 of the conductive layer CL1. In addition, a pattern 2P3 that connects the source terminal of the switching element SWH and the drain terminal of the switching element SWL is included. Further included are a via 2V5 connected to a terminal of the driver 4H of the conductive layer CL1, a via 2V6 connected to a terminal of the driver 4L of the conductive layer CL1, a signal line SL1 connecting the via 2V3 and the via 2V5, a signal line SL2 connecting the via 2V4 and the via 2V6, and a wiring line GL connecting gate terminals of the switching elements SWH and SWL to the respective vias 2V5 and 2V6. Note that, regarding the wiring line GL, although a gate terminal side is indicated by arrows, the wiring line GL is actually connected to the gate terminals.

In addition, as shown in FIG. 10, the conductive layer CL5 includes a conductor pattern 5P1 connected through a via to the pattern 4P1 of the conductive layer CL4 and the pattern 4P2 to which the drain terminal of the switching element SWH is connected, a conductor pattern 5P2 connected through a via to the pattern 4P3 of the conductive layer CL4, to which the drain terminal of the switching element SWL is connected, and a via 5V1 connected to the via 4V1 of the conductive layer CL4. Furthermore, a pattern 5P3 that connects the via 5V1 of the conductive layer CL5 and the conductor pattern 5P2 is included.

Also in such a built-in substrate 1, as in the first embodiment described above, heat generated in the conductor patterns 5P1 and 5P2 can be dissipated via the conductive layer CL5.

In the first embodiment described above, the first surface CL1A has been described as being the mounting surface on one end side (stacking direction Z1 side) in the stacking direction Z. However, the first surface CL1A may be a mounting surface of an inner layer in the built-in substrate 1. That is, the connector CN1 to which the power supply line 2P is connected, the connector CN2 to which the power supply line 2N is connected, the connector CN3 to which the motor M is connected, the connector CN4 that inputs, to the drivers 4H and 4L, control signals transmitted from the control unit 5 to the switching elements SWH and SWL, the connector CN5 that supplies power to the driver 4H, the connector CN6 that supplies power to the driver 4L, the driver 4H for driving the switching element SWH, and the driver 4L for driving the switching element SWL may be mounted on any of the conductive layers CL2, CL3, CL4, and CL5.

In the first embodiment described above, the insulating layer IL5 between the conductive layer CL6 and the conductive layer CL5 has been described as being formed using a material having a higher thermal conductivity than those of the other insulating layers IL1, IL2, IL3, and IL4. However, the insulating layer IL5 between the conductive layer CL6 and the conductive layer CL5 may be formed using a material having a thermal conductivity on the same level as those of the other insulating layers IL1, IL2, IL3, and IL4, or may be formed using a material having a lower thermal conductivity than those of the other insulating layers IL1, IL2, IL3, and IL4.

In the first embodiment described above, the conductive layer CL6 has been described as being used for dissipating heat from the switching element SWH and the switching element SWL. However, the conductive layer CL6 may be used as the conductive layer CL through which a current flows. In this case, the insulating layer IL5 between the conductive layer CL5 and the conductive layer CL6 is preferably used as the insulating layer IL that insulates between two conductive layers CL, similarly to the other insulating layers IL1, IL2, IL3, and IL4, and a heat transfer sheet is preferably provided on the stacking direction Z2 side of the conductive layer CL6. In such a configuration, the influence of noise between a component disposed on the stacking direction Z2 side of the heat transfer sheet and the switching element SWH and the switching element SWL can be reduced.

### 3. Overview of First Embodiment

The overview of the built-in substrate 1 described above will be described below.
(1) The built-in substrate 1 is a built-in substrate 1 in which a plurality of conductive layers CL are stacked with insulating layers IL interposed therebetween and a switching element SWH, SWL (power device) is incorporated on a center side in a stacking direction Z, and includes a conductive layer CL1 (first conductive layer) on one side in the stacking direction Z among the plurality of the conductive layers CL, the conductive layer CL1 having a first surface CL1A on which an electronic component 21 different from the switching element SWH, SWL is mounted, a conductive layer CL6 (second conductive layer) on the other end side in the stacking direction Z among the plurality of the conductive layers CL, the conductive layer CL6 having a second surface CL6A used as a heat dissipation surface that dissipates heat from the switching element SWH, SWL, and a conductive layer CL5 (third conductive layer) in which a conductor pattern 5P1, 5P2 through which a current supplied to the switching element SWH, SWL flows and that is insulated from the conductive layer CL6 is formed, and which is provided between the switching element SWH, SWL and the conductive layer CL6 so as to face the conductive layer CL6.
   According to the present configuration, the conductor pattern 5P1, 5P2 of the conductive layer CL5, through which the current supplied to the switching element SWH, SWL flows, generate heat depending on the magnitude of the current. Furthermore, the switching element SWH, SWL also generates heat due to energization. According to the present configuration, since the conductor pattern 5P1, 5P2 is provided to face the conductive layer CL6 having the second surface CL6A used as the heat dissipation surface, heat of each of the switching element SWH, SWL and the conductive layer CL5 including the conductor pattern 5P1, and 5P2 can be efficiently dissipated via the second surface CL6A.
(2) In the built-in substrate 1 described in (1), when the switching element SWH, SWL and the conductive layer CL5 are viewed along the stacking direction Z, a mounting region of the switching element SWH, SWL is preferably included in the conductor pattern 5P1, 5P2.
   According to the present configuration, the heat capacity of the conductor pattern 5P1, 5P2 to which heat from the switching element SWH, SWL is transferred can be increased. Therefore, it is possible to improve the cooling effect for the switching element SWH, SWL.
(3) In the built-in substrate 1 described in (1) or (2), the switching element SWH, SWL and the conductor pattern 5P1, 5P2 are preferably electrically connected through a via V provided over the entire mounting region of the switching element SWH, SWL.
   According to the present configuration, electrical resistance and thermal resistance between the switching element SWH, SWL and the conductor pattern 5P1, 5P2 can be reduced. Therefore, heat generated in the built-in substrate 1 can be reduced, and heat generated in the switching element SWH, SWL can be efficiently dissipated.
(4) In the built-in substrate 1 described in any one of (1) to (3), it is preferable that the first surface CL1A be a mounting surface on one end side in the stacking direction Z, a plurality of electrodes electrically connected to each of the battery 2 that supplies power to the switching element SWH, SWL and the motor M (load) energized via the switching element SWH, SWL be provided on the first surface CL1A, and the plurality of electrodes be electrically connected to the conductor pattern 5P1, 5P2.
   According to the present configuration, the current flowing through the switching element SWH, SWL flows through the conductor pattern 5P1, 5P2. Therefore, heat generated in the switching element SWH, SWL can be efficiently dissipated.
(5) In the built-in substrate 1 described in any one of (1) to (3), among the plurality of insulating layers IL, the insulating layer IL5 between the conductive layer CL6 and the conductive layer CL5 is preferably formed using a material having a higher thermal conductivity than other insulating layers IL1, IL2, IL3, and IL4.

According to the present configuration, heat transfer between the conductive layer CL5 and the conductive layer CL6 can be facilitated, while heat transfer between the conductive layer CL5 and the insulating layer IL4 can be suppressed. Therefore, heat of the switching element SWH and the switching element SWL can be easily dissipated via the conductive layer CL6.

### 4. Second Embodiment

Next, a second embodiment of the built-in substrate 1 according to the first embodiment described above will be described. In the following, for ease of understanding, the built-in substrate is described as a built-in substrate 101 in the second embodiment.

The built-in substrate 101 of the second embodiment is configured to appropriately dissipate heat generated in a power device incorporated in the built-in substrate 101 and a pattern formed in the built-in substrate. The built-in substrate 101 of the present embodiment will be described below. However, the built-in substrate 101 is not limited to the following embodiment and may be modified in various ways without departing from the gist of the built-in substrate 101.

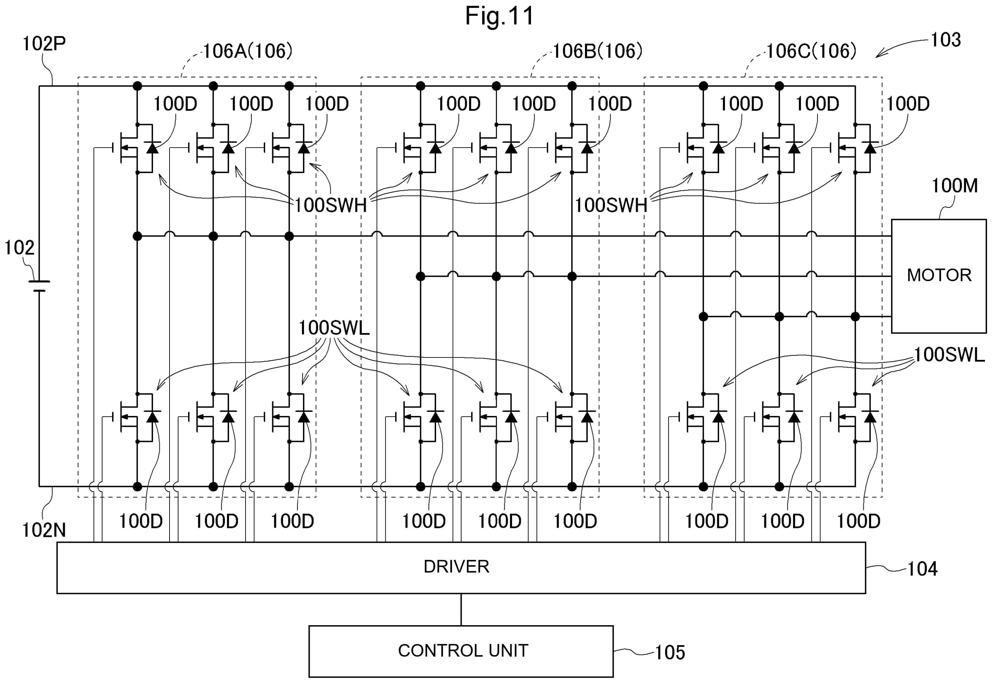

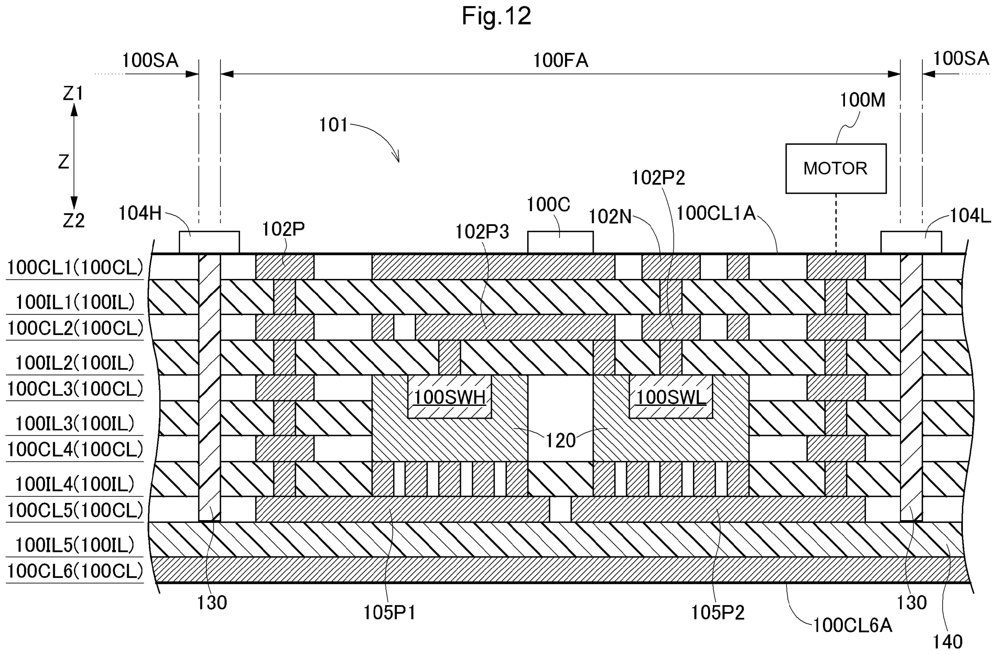

FIG. 11 is a circuit diagram of a circuit partially formed in the built-in substrate 101 (see FIG. 12) of the present embodiment. FIG. 11 shows an inverter 103 that converts DC power from a battery 102 into AC power and drives a motor 100M. A three-phase motor is used as the motor 100M. For this reason, the inverter 103 includes three legs 106 (hereinafter referred to as legs 106A, 106B, and 106C), each including a high-side switching element 100SWH (an example of "power device") and a low-side switching element 100SWL (an example of "power device") connected in series to each other. For example, n-type metal-oxide-semiconductor field-effect transistors (MOS-FETs) are used as the switching elements 100SWH and 100SWL.

The three legs 106A, 106B, and 106C are connected in parallel with each other to a power supply line 102P connected to a positive electrode of the battery 102 and a power supply line 102N connected to a negative electrode of the battery 102. In each of the legs 106A, 106B, and 106C, a drain terminal of the switching element 100SWH is connected to the power supply line 102P, and a source terminal of the switching element 100SWL is connected to the power supply line 102N. The source terminal of the switching element 100SWH and the drain terminal of the switching element 100SWL are connected to each other. In each of the switching element 100SWH and the switching element 100SWL, a diode 100D is provided across the source terminal and the drain terminal. The source terminal of the switching element 100SWH of each of the plurality of legs 106A, 106B, and 106C is connected to a terminal of the motor 100M.

The gate terminal of each of the switching element 100SWH and the switching element 100SWL is connected to a control unit 105 via a driver 104. Accordingly, the inverter 103 converts the DC power from the battery 102 into three-phase AC power by sequentially switching a state in which the high-side switching element 100SWH of a predetermined one of the three legs and the low-side switching element 100SWL of one of the remaining two legs are brought into a closed state and other switching elements are brought into an open state. The motor 100M is driven by supplying such three-phase AC power to the motor 100M.

In the present embodiment, as shown in FIG. 11, the three legs 106A, 106B, and 106C each include three sets of the switching element 100SWH and the switching element 100SWL connected in series to each other.

As shown in FIG. 12, in the built-in substrate 101, a plurality (six in the present embodiment) of conductive layers 100CL are stacked with insulating layers 100IL interposed therebetween. In the following, the six conductive layers 100CL are referred to as a conductive layer 100CL1, a conductive layer 100CL2, a conductive layer 100CL3, a conductive layer 100CL4, a conductive layer 100CL5, and a conductive layer 100CL6, and the conductive layer 100CL1, the conductive layer 100CL2, the conductive layer 100CL3, the conductive layer 100CL4, the conductive layer 100CL5, and the conductive layer 100CL6 are stacked in this order from the top. In addition, an insulating layer 100IL1 is interposed between the conductive layer 100CL1 and the conductive layer 100CL2, an insulating layer 100IL2 is interposed between the conductive layer 100CL2 and the conductive layer 100CL3, an insulating layer 100IL3 is interposed between the conductive layer 100CL3 and the conductive layer 100CL4, an insulating layer 100IL4 is interposed between the conductive layer 100CL4 and the conductive layer 100CL5, and an insulating layer 100IL5 is interposed between the conductive layer 100CL5 and the conductive layer 100CL6.

Here, the direction in which the six conductive layers 100CL are stacked is defined as a stacking direction Z. As shown in FIG. 12, in the built-in substrate 101, the switching elements 100SWH and 100SWL included in a predetermined leg 106 are incorporated in a central portion in the stacking direction Z. In the stacking direction Z, the conductive layer 100CL1 side as viewed from the switching element 100SWH and the switching element 100SWL is defined as a stacking direction Z1 side, and the conductive layer 100CL6 side as viewed from the switching element 100SWH and the switching element 100SWL is defined as a stacking direction Z2 side.

The conductive layer 100CL1 corresponds to a sixth conductive layer on one end side (the stacking direction Z1 side) in the stacking direction Z. The conductive layer 100CL6 corresponds to a first conductive layer on the other end side (stacking direction Z2 side) in the stacking direction Z. In addition, as described in detail later, the conductive layer 100CL5 corresponds to a second conductive layer.

In the present embodiment, one built-in substrate 101 is provided with the switching element 100SWH and the switching element 100SWL of one leg 106 among the three legs 106A, 106B, and 106C described above. In addition, in one built-in substrate 101, three switching elements 100SWH are provided to be connected in parallel with each other, and three switching elements 100SWL are provided to be connected in parallel with each other.

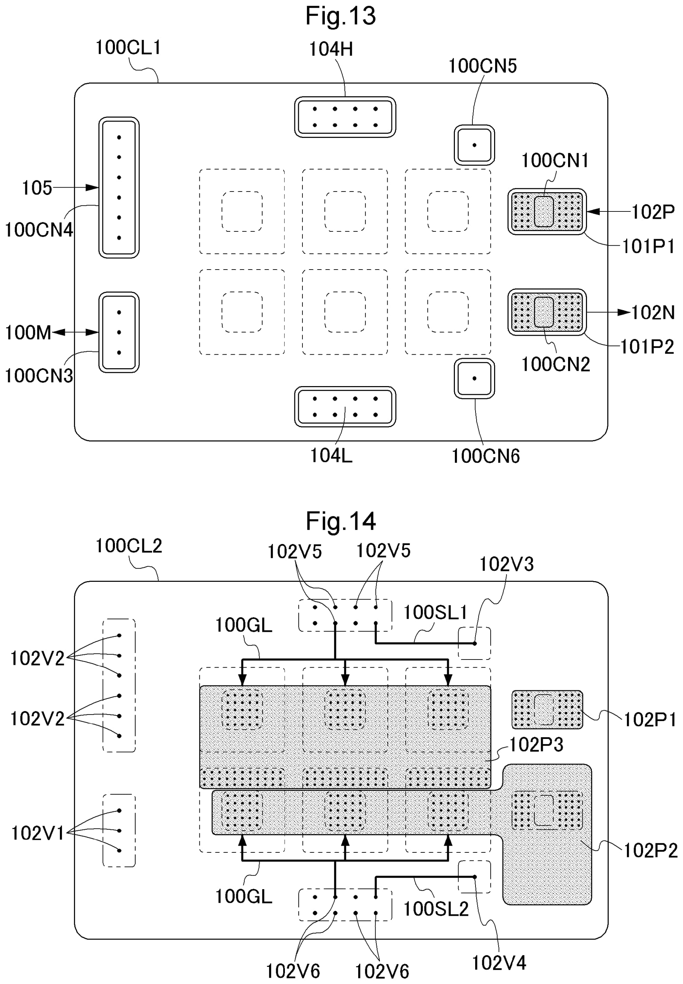

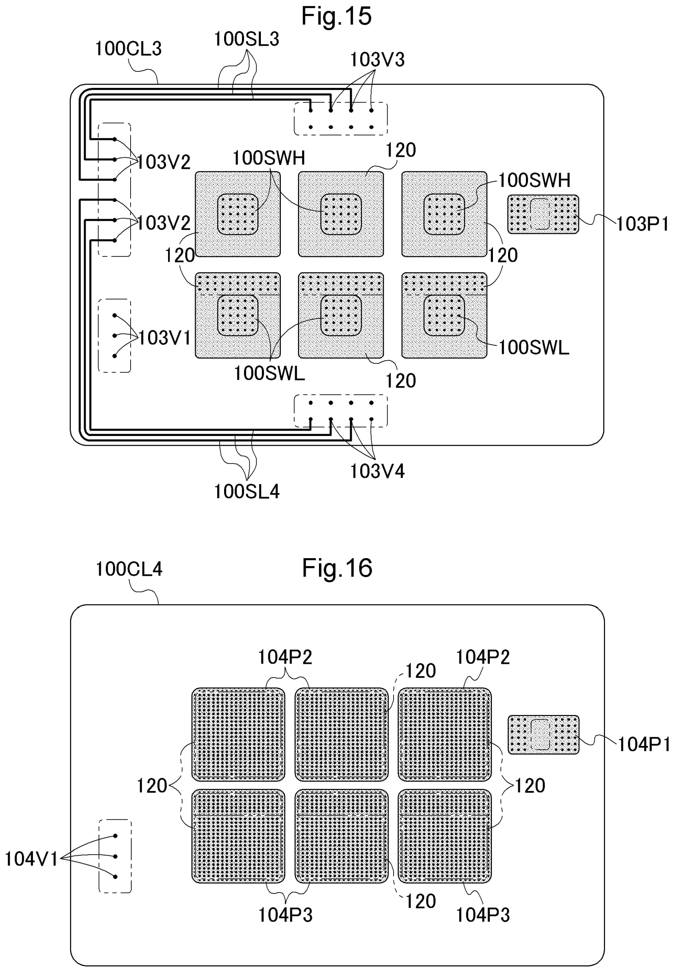

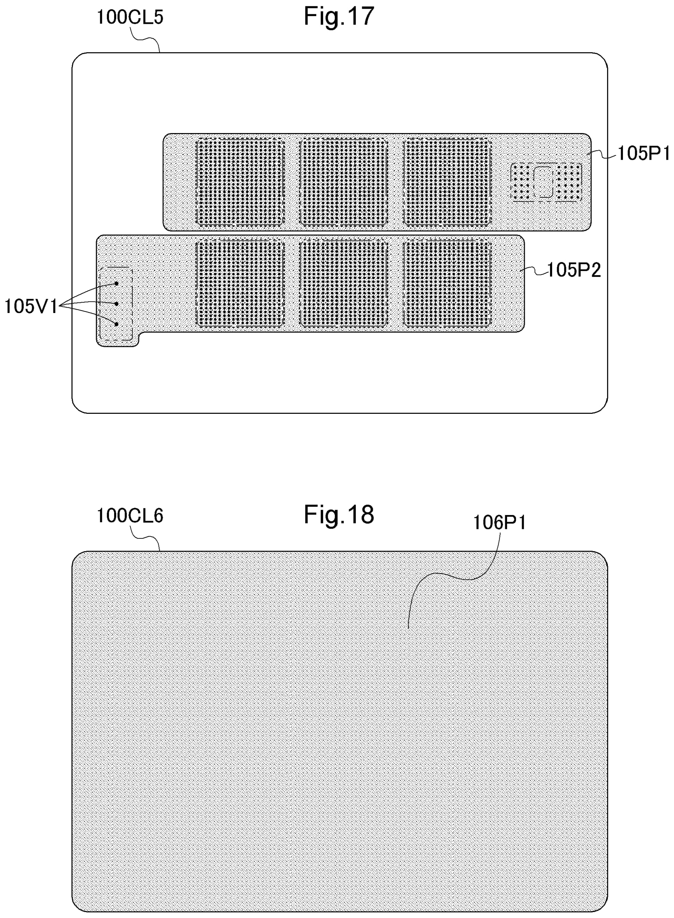

FIG. 13 shows a plan view of the conductive layer 100CL1, FIG. 14 shows a plan view of the conductive layer 100CL2, and FIG. 15 shows a plan view of the conductive layer 100CL3. Furthermore, FIG. 16 shows a plan view of the conductive layer 100CL4, FIG. 17 shows a plan view of the conductive layer 100CL5, and FIG. 18 shows a plan view of the conductive layer 100CL6.

As shown in FIG. 13, on the conductive layer 100CL1, a connector 100CN1 to which the power supply line 102P is connected, a connector 100CN2 to which the power supply line 102N is connected, a connector 100CN3 to which the motor 100M is connected, a connector 100CN4 that inputs, to the driver 104 (drivers 104H and 104L described later), control signals transmitted from the control unit 105 to the switching elements 100SWH and 100SWL, a connector 100CN5 that supplies power to the driver 104H, a connector 100CN6 that supplies power to the driver 104L, a driver 104H for driving the switching element 100SWH, and a driver 104L for driving the switching element 100SWL are mounted. The connectors 100CN1 to 100CN6 and the drivers 104H and 104L are mounted on a first surface 100CL1A on the stacking direction Z1 side of the conductive layer 100CL1. It goes without saying that, in addition to these components, a capacitor 100C having a relatively small amount of heat generation, a resistor (not shown), and the like may be mounted on the first surface 100CL1A. Note that, in the present embodiment, "connect" means "connect in a state in which current flows".

As shown in FIG. 14, the conductive layer 100CL2 includes a pattern 102P1 connected through a via to a land 101P1 on which the connector 100CN1 of the conductive layer 100CL1 is mounted, a pattern 102P2 connected through a via to a land 101P2 on which the connector 100CN2 of the conductive layer 100CL1 is mounted, a via 102V1 connected to a terminal of the connector 100CN3 of the conductive layer 100CL1, a via 102V2 connected to a terminal of the connector 100CN4 of the conductive layer 100CL1, a via 102V3 connected to a terminal of the connector 100CN5 of the conductive layer 100CL1, and a via 102V4 connected to a terminal of the connector 100CN6 of the conductive layer 100CL1. In addition, a pattern 102P3 that connects the source terminal of the switching element 100SWH and the drain terminal of the switching element 100SWL is included. Further included are a via 102V5 connected to a terminal of the driver 104H of the conductive layer 100CL1, a via 102V6 connected to a terminal of the driver 104L of the conductive layer 100CL1, a signal line 100SL1 connecting the via 102V3 and the via 102V5, a signal line 100SL2 connecting the via 102V4 and the via 102V6, and a wiring line 100GL connecting gate terminals of the switching elements 100SWH and 100SWL to the respective vias 102V5 and 102V6. Note that, regarding the wiring line 100GL, although a gate terminal side is indicated by arrows, the wiring line 100GL is actually connected to the gate terminals.

In the built-in substrate 101, the switching element 100SWH and the switching element 100SWL are incorporated on the central side in the stacking direction Z. In the present embodiment, the switching element 100SWH and the switching element 100SWL are each placed on a base member 120. The base member 120 of the present embodiment is formed by, for example, a rectangular columnar body or a plate-shaped body. As shown in FIGS. 15 and 16, the base member 120, the switching element 100SWH, and the switching element 100SWL are provided across the conductive layer 100CL3 and the conductive layer 100CL4.

In addition, as shown in FIG. 15, the conductive layer 100CL3 includes a pattern 103P1 connected through a via to the pattern 102P1 of the conductive layer 100CL2, a via 103V1 connected to the via 102V1 of the conductive layer 100CL2, a via 103V2 connected to 102V2 of the conductive layer 100CL2, a via 103V3 connected to the via 102V5 of the conductive layer 100CL2, and a via 103V4 connected to 102V6 of the conductive layer 100CL2. Furthermore, a signal line 100SL3 connecting the via 103V2 and the via 103V3 of the conductive layer 100CL3, and a signal line 100SL4 connecting the via 103V2 and the via 103V4 of the conductive layer 100CL3 are included.

As shown in FIG. 16, the conductive layer 100CL4 includes a pattern 104P1 connected through a via to the pattern 103P1 of the conductive layer 100CL3, and a via 104V1 connected to the via 103V1 of the conductive layer 100CL3. Furthermore, a pattern 104P2 connected to a bottom surface of the base member 120 on which the switching element 100SWH is placed, and a pattern 104P3 connected to a bottom surface of the base member 120 on which the switching element 100SWL is placed are included.

As shown in FIG. 17, the conductive layer 100CL5 includes a pattern 105P1 connected through a via to the pattern 104P1 of the conductive layer 100CL4 and the pattern 104P2 to which the drain terminal of the switching element 100SWH is connected, and a pattern 105P2 connected through a via to the pattern 104P3 of the conductive layer 100CL4, to which the drain terminal of the switching element 100SWL is connected, and connected to a via 105V1 connected to the via 104V1 of the conductive layer 100CL4.

As shown in FIG. 18, the conductive layer 100CL6 includes a pattern 106P1 insulated from each of the conductive layers 100CL1 to 100CL5 and formed over an entire surface. This pattern 106P1 is connected to, for example, a housing of the inverter 103 through a harness or a screw.

Note that, although not shown, the conductive layers 100CL1 to 100CL5 are preferably provided with grounded patterns at portions different from the respective patterns and wiring lines described above.

A second surface 100CL6A of the conductive layer 100CL6 on the stacking direction Z2 side is used as a heat dissipation surface that dissipates heat from the switching element 100SWH and the switching element 100SWL. Therefore, the conductive layer 100CL6 has the second surface 100CL6A that dissipates heat from the switching element 100SWH and the switching element 100SWL. Here, the switching elements 100SWH and 100SWL generate heat in response to energization. This heat reaches the conductive layer 100CL6 through the conductive layer 100CL5 and the insulating layer 100IL5 between the conductive layer 100CL6 and the conductive layer 100CL5 provided to face the conductive layer 100CL6, and is dissipated from the conductive layer 100CL6. The insulating layer 100IL5 is preferably formed using a heat transfer layer 140 made of a material having a relatively high thermal conductivity in order to transfer heat from the conductive layer 100CL5 to the conductive layer 100CL6 and efficiently perform heat transfer.

Here, currents in the built-in substrate 101, in particular, flows of source currents and drain currents of the switching elements 100SWH and 100SWL, will be described. As shown in FIG. 12, the power supply line 102P is formed in the conductive layer 100CL1. The power supply line 102P is electrically connected to the conductive layer 100CL2 via a via provided in the insulating layer 100IL1, the conductive layer 100CL2 is electrically connected to the conductive layer 100CL3 via a via provided in the insulating layer 100IL2, the conductive layer 100CL3 is electrically connected to the conductive layer 100CL4 via a via provided in the insulating layer 100IL3, and the conductive layer 100CL4 is electrically connected to a conductor pattern (pattern 105P1) of the conductive layer 100CL5 via a via provided in the insulating layer 100IL4. This conductor pattern is electrically connected to the drain terminal of the switching element 100SWH via a via provided in the insulating layer 100IL4 and the base member 120. Therefore, a drain current of the switching element 100SWH flows from the power supply line 102P through the pattern 105P1 via the respective conductive layers 100CL and vias.

The source terminal of the switching element 100SWH is electrically connected to the conductive layer 100CL2 via a via provided in the insulating layer 100IL2, and the conductive layer 100CL2 is electrically connected to a conductor pattern (pattern 105P2) via a via provided in the insulating layer 100IL2, the base member 120 of the switching element 100SWL, and a via provided in the insulating layer 100IL4. Therefore, a source current of the switching element 100SWH flows from the source terminal of the switching element 100SWH to the pattern 105P2 via the via provided in the insulating layer 100IL2, the base member 120 of the switching element 100SWL, and the via provided in the insulating layer 100IL4.

Furthermore, the pattern 105P2 is electrically connected to the conductive layer 100CL4 via a via provided in the insulating layer 100IL4, the conductive layer 100CL4 is electrically connected to the conductive layer 100CL3 via a via provided in the insulating layer 100IL3, the conductive layer 100CL3 is electrically connected to the conductive layer 100CL2 via a via provided in the insulating layer 100IL2, and the conductive layer 100CL2 is electrically connected to the conductive layer 100CL1 via a via provided in the insulating layer 100IL1. The conductive layer 100CL1 is electrically connected to a terminal that the motor 100M has. Therefore, the source current of the switching element 100SWH temporarily flows from the conductive layer 100CL2 to the conductive layer 100CL5, and further flows to the conductive layer 100CL1. In addition, a current from the motor 100M flows from the conductive layer 100CL1 to the pattern 105P2 via the respective conductive layers and vias (corresponding to a drain current of the switching element 100SWL).

The pattern 105P2 is electrically connected to the drain terminal of the switching element 100SWL via the base member 120, and the source terminal of the switching element 100SWL is electrically connected to the conductive layer 100CL2 via a via provided in the insulating layer 100IL2 and is further electrically connected to the power supply line 102N provided in the conductive layer 100CL1 via a via provided in the insulating layer 100IL1. Therefore, a source current of the switching element 100SWL flows from the source terminal of the switching element 100SWL to the power supply line 102N via the via provided in the insulating layer 100IL2, the conductive layer 100CL2, and the via provided in the insulating layer 100IL1.

As described above, the conductive layer 100CL5 includes the pattern 105P1 connected through a via to the drain terminal of the switching element 100SWH, and the pattern 105P2 connected through a via to the drain terminal of the switching element 100SWL. Therefore, the conductive layer 100CL5 is formed with the patterns 105P1 and 105P2 through which a current supplied to the switching elements 100SWH and 100SWL flows and which are insulated from the conductive layer 100CL6, and is provided to face the conductive layer 100CL6. The current supplied to the switching elements 100SWH and 100SWL means a current flowing into the switching elements 100SWH and 100SWL. That is, in the switching element 100SWH, the current corresponds to a current flowing from the battery 102 via the power supply line 102P, and in the switching element 100SWL, the current corresponds to a current flowing from the motor 100M. Therefore, in the conductive layer 100CL5, the pattern 105P1 through which a current supplied to the switching element 100SWH flows and which is insulated from the conductive layer 100CL6, and the pattern 105P2 through which a current supplied to the switching element 100SWL flows and which is insulated from the conductive layer 100CL6 are formed. Furthermore, both the pattern 105P1 and the pattern 105P2 are insulated from the conductive layer 100CL6.

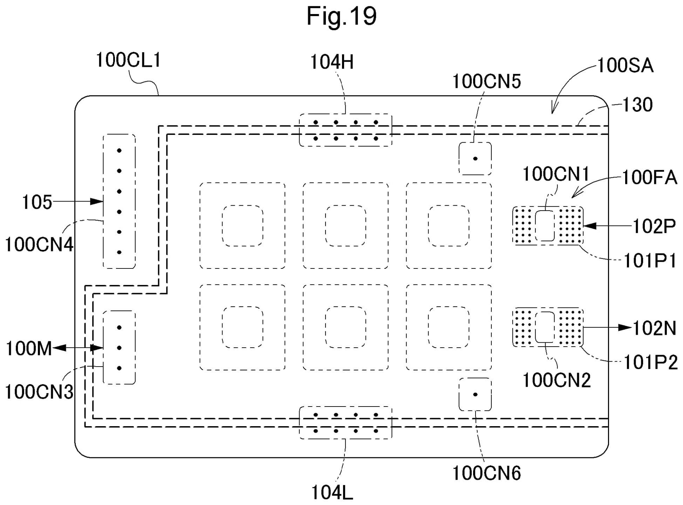

As shown in FIG. 19, the built-in substrate 101 is divided into a first region 100FA and a second region 100SA when viewed along the stacking direction Z. "When viewed along the stacking direction Z" means that the built-in substrate 101 is viewed from the stacking direction Z1 side or the stacking direction Z2 side.

The first region 100FA is a region in which the switching elements 100SWH and 100SWL are incorporated and which includes conductive patterns through which a current supplied to the switching elements 100SWH and 100SWL among the plurality of conductive layers 100CL flows. The conductive patterns through which the current supplied to the switching elements 100SWH and 100SWL flows are patterns connected to the source terminals and the drain terminals of the respective switching elements 100SWH and 100SWL. Specifically, the conductive patterns correspond to a pattern extending from the power supply line 102P to the pattern 105P1, the pattern 105P1, the pattern 102P3, the pattern 105P2, a pattern extending from the pattern 105P2 to the power supply line 102N, a wiring line 100GL connecting each of the drivers 104H and 104L to a gate terminal of each of the switching elements 100SWH and 100SWL, a signal line 100SL1 connecting the via 102V3 and the via 102V5, and a signal line 100SL2 connecting the via 102V4 and the via 102V6.

The second region 100SA is a region having an amount of heat generation smaller than the amount of heat generation in the first region 100FA. The region having an amount of heat generation smaller than the amount of heat generation in the first region 100FA corresponds to, for example, signal lines 100SL3 and 100SL4 connecting the via 103V2 of the connector 100CN4 and the respective drivers 104H and 104L. Since a relatively large current does not flow through these signal lines 100SL3 and 100SL4, the amount of heat generation is small.

In the present embodiment, the first region 100FA is a high-voltage region in which the applied voltage applied to the conductive patterns included in the plurality of conductive layers 100CL included in the first region 100FA is relatively high, and the second region 100SA is a low-voltage region in which the applied voltage applied to the conductive patterns included in the plurality of conductive layers 100CL included in the second region 100SA is relatively low. Therefore, as described above, the amount of heat generation in the second region 100SA is smaller than the amount of heat generation in the first region 100FA.

In the present embodiment, as shown in FIG. 19, the second region 100SA is provided outside the outer edge portion of the first region 100FA when viewed along the stacking direction Z. The second region 100SA is provided in at least part of the outer peripheral region of the first region 100FA in a plan view of the built-in substrate 101. In the example of FIG. 19, the second region 100SA is provided on three sides of the built-in substrate 101. Therefore, the second region 100SA need not be provided over the entire periphery of the first region 100FA.

A high thermal resistance portion 130 having a thermal resistance higher than a thermal resistance of the conductive layer 100CL6 is provided between the first region 100FA and the second region 100SA. As shown in FIG. 19, the high thermal resistance portion 130 is provided along the boundary between the first region 100FA and the second region 100SA. Furthermore, as shown in FIG. 12, the high thermal resistance portion 130 is provided from the conductive layer 100CL1 to the conductive layer 100CL5. Such a high thermal resistance portion 130 is formed by a resin portion having no conductor portion in the built-in substrate 101. Therefore, the conductive layers 100CL1 to 100CL5 in the first region 100FA and the conductive layers 100CL1 to 100CL5 in the second region 100SA are thermally separated from each other.

In the present embodiment, the high thermal resistance portion 130 is configured to insulate the first region 100FA and the second region 100SA from each other. Therefore, the high thermal resistance portion 130 is preferably made of a material having high thermal resistance and high insulation resistance.

In the present embodiment, the conductive layer 100CL6 and the heat transfer layer 140 are provided from the first region 100FA to the second region 100SA when viewed along the stacking direction Z. That is, the conductive layer 100CL6 and the heat transfer layer 140 are continuously provided between the first region 100FA and the second region 100SA without being cut by the high thermal resistance portion 130. As a result, heat transferred to the patterns 105P1 and 105P2 can escape from the first region 100FA to the second region 100SA via the heat transfer layer 140.

With the configuration described above, heat from the switching element 100SWH is transferred to the pattern 105P1, heat from the switching element 100SWL is transferred to the pattern 105P2, and the heat transferred to the pattern 105P1 and the pattern 105P2 can be transferred to the conductive layer 100CL6 via the heat transfer layer 140 and dissipated. Furthermore, heat can be transferred from the first region 100FA via the heat transfer layer 140 to the second surface of the conductive layer 100CL6 on the second region 100SA side and dissipated.

Moreover, the conductive patterns included in the first region 100FA have a relatively high applied voltage, and the conductive patterns included in the second region 100SA have a relatively low applied voltage. As in the present embodiment, by providing the high thermal resistance portion 130 formed using an insulating material between the first region 100FA and the second region 100SA, components provided in the second region 100SA having a relatively low absolute maximum rated voltage can be protected from a high voltage.

### 5. Modified Example of Second Embodiment

Next, a modified example of the built-in substrate 101 will be described.

In the second embodiment described above, the power devices have been described with the switching elements 100SWH and 100SWL as examples, but the power device provided in the built-in substrate 101 may be a single switching element rather than a plurality of switching elements. In addition, the power device need not be an n-type metal-oxide-semiconductor field-effect transistor (MOS-FET), and may be a p-type MOS-FET, may be an insulated gate bipolar transistor (IGBT), or may be a bipolar transistor. Furthermore, the power device need not be the switching elements 100SWH and 100SWL, and may be, for example, a load switch or another component that generates heat in response to energization.

In the second embodiment described above, an example in which the driver 104 is mounted on the built-in substrate 101 has been described. However, the driver 104 may be provided on a substrate different from the built-in substrate 101.

In the second embodiment described above, the description has been made assuming that the three legs 106A, 106B, and 106C each include three sets of the switching element 100SWH and the switching element 100SWL connected in series to each other. However, the three legs 106A, 106B, and 106C may also each be configured to include one set of the switching element 100SWH and the switching element 100SWL connected in series to each other.

In the second embodiment described above, an example has been described in which the built-in substrate 101 is provided with three switching elements 100SWH connected in parallel with each other and three switching elements 100SWL connected in parallel with each other, the switching elements 100SWH and 100SWL being included in one leg 106 among the three legs 106. However, the switching elements 100SWH and the switching elements 100SWL of the three legs 106 may be provided in the built-in substrate 101.

In the second embodiment described above, the second region 100SA has been described as being provided outside the outer edge portion of the first region 100FA when viewed along the stacking direction Z. However, the second region 100SA may be provided in a central portion of the first region 100FA when viewed along the stacking direction Z.

In the second embodiment described above, the insulating layer 100IL5 between the conductive layer 100CL6 and the conductive layer 100CL5 provided to face the conductive layer 100CL6 has been described as being the heat transfer layer 140 that transfers heat from the conductive layer 100CL5 to the conductive layer 100CL6. However, the insulating layer 100IL5 between the conductive layer 100CL6 and the conductive layer 100CL5 provided to face the conductive layer 100CL6 need not be the heat transfer layer 140 and may be formed by an insulating material similar to the other insulating layers 100IL.

In the second embodiment described above, the conductive layer 100CL6 and the heat transfer layer 140 have been described as being provided from the first region 100FA side to the second region 100SA side when viewed along the stacking direction Z. However, the conductive layer 100CL6 and the heat transfer layer 140 may also be provided without extending from the first region 100FA side to the second region 100SA side when viewed along the stacking direction Z.

In the second embodiment described above, the high thermal resistance portion 130 has been described as insulating the first region 100FA and the second region 100SA from each other. However, the high thermal resistance portion 130 may also be formed without using a material that insulates the first region 100FA and the second region 100SA from each other.

Note that the conductor patterns of the respective conductive layers 100CL1 to 100CL6 described in the second embodiment described above are examples and may be changed.

### 6. Overview of Second Embodiment

The overview of the built-in substrate 101 described above will be described below.
(1) The built-in substrate 101 is a built-in substrate 101 in which a plurality of conductive layers CL are stacked with insulating layers 100IL interposed therebetween and a switching element 100SWH, 100SWL (power device) is incorporated on a center side in a stacking direction Z, when viewed along the stacking direction Z, the built-in substrate 101 is divided into a first region 100FA in the plurality of conductive layers 100CL in which the switching element 100SWH, 100SWL is incorporated and which includes a pattern 105P1, 105P2 through which a current supplied to the switching element 100SWH, 100SWL flows, and a second region 100SA having an amount of heat generation smaller than an amount of heat generation in the first region 100FA, a conductive layer 100CL6 (first conductive layer) on one end side in the stacking direction Z among the plurality of conductive layers 100CL has a second surface 100CL6A (heat dissipation surface) that dissipates heat from the switching element 100SWH, 100SWL, and a high thermal resistance portion 130 having a thermal resistance higher than a thermal resistance of the conductive layer 100CL6 is provided between the first region 100FA and the second region 100SA.
   The pattern 105P1, 105P2 of the conductive layer 100CL5, through which the current supplied to the switching element 100SWH, 100SWL flows, generates heat depending on the magnitude of the current. Furthermore, the switching element 100SWH, 100SWL also generates heat due to energization. According to the present configuration, the high thermal resistance portion 130 is provided between the first region 100FA and the second region 100SA. For this reason, heat of the switching element 100SWH, 100SWL and the patterns of the conductive layers 100CL is more easily transferred to the conductive layer 100CL6 having the second surface 100CL6A (heat dissipation surface) than to the second region 100SA, and such heat can be efficiently dissipated. Moreover, since the high thermal resistance portion 130 is provided between the first region 100FA and the second region 100SA, a space for heat measures does not need to be provided over the first region 100FA and the second region 100SA. As a result, an increase in substrate size can be suppressed. Therefore, a small built-in substrate 1 that can efficiently dissipate heat can be obtained.
(2) In the built-in substrate 101 described in (1), the second region 100SA is preferably provided outside an outer edge portion of the first region 100FA when viewed along the stacking direction Z.
   According to the present configuration, the second region 100SA, which has a relatively small amount of heat generation, is less affected by heat between components arranged in the second region 100SA, and thus the degree of freedom in mounting can be increased. Therefore, pattern design (patterning) can be easily performed without placing importance on thermal design. Furthermore, when a plurality of built-in substrates are arranged adjacent to each other, the influence of heat between the built-in substrates is small, and thus the degree of freedom in arrangement of the built-in substrates 101 can also be increased.
(3) In the built-in substrate 101 described in (1) or (2), it is preferable that an insulating layer 100IL5 between the conductive layer 100CL6 and the conductive layer 100CL5 (second conductive layer) provided to face the conductive layer 100CL6 be a heat transfer layer 140 that transfers heat from the conductive layer 100CL5 to the conductive layer 100CL6, and the conductive layer 100CL6 and the heat transfer layer 140 be provided from the first region 100FA side to the second region 100SA side when viewed along the stacking direction Z.
   According to the present configuration, heat in the first region 100FA can be dissipated via the second surface 100CL6A of the conductive layer 100CL6 on the second region 100SA side. Therefore, heat dissipation performance of the built-in substrate 101 can be improved.
(4) In the built-in substrate 101 described in (1) or (2), it is preferable that the first region 100FA be a high-voltage region in which an applied voltage applied to conductive patterns included in the plurality of conductive layers 100CL included in the first region 100FA is relatively high, the second region 100SA be a low-voltage region in which an applied voltage applied to conductive patterns included in the plurality of conductive layers 100CL included in the second region 100SA is relatively low, and the high thermal resistance portion 130 insulate the first region 100FA and the second region 100SA from each other.

According to the present configuration, insulation between the first region 100FA and the second region 100SA can be performed using the high thermal resistance portion 130. For this reason, it is not necessary to separately provide an insulation space between the first region 100FA and the second region 100SA. Therefore, an increase in size of the built-in substrate 101 can be suppressed.

### INDUSTRIAL APPLICABILITY

The technology according to the present disclosure can be used for a built-in substrate in which a power device is incorporated.

### REFERENCE SIGNS LIST

1: Built-in substrate, 2: Battery, 5P1: Conductor pattern, 5P2: Conductor pattern, CL: Conductive layer, CL1: Conductive layer (first conductive layer), CL1A: First surface, CL2A: Second surface, CL5: Conductive layer (third conductive layer), CL6: Conductive layer (second conductive layer), IL: Insulating layer, IL1: Insulating layer, IL2: Insulating layer, IL3: Insulating layer, IL4: Insulating layer, IL5: Insulating layer, M: Motor (load), SWH: Switching element (power device), SWL: Switching element (power device), V: Via, and Z: Stacking direction

## Claims

1. A built-in substrate in which a plurality of conductive layers are stacked with insulating layers interposed therebetween and a power device is incorporated on a center side in a stacking direction, the built-in substrate comprising:
a first conductive layer on one side in the stacking direction among the plurality of the conductive layers, the first conductive layer having a first surface on which an electronic component different from the power device is mounted;
a second conductive layer on the other end side in the stacking direction among the plurality of the conductive layers, the second conductive layer having a second surface used as a heat dissipation surface that dissipates heat from the power device; and
a third conductive layer in which a conductor pattern through which a current supplied to the power device flows and that is insulated from the second conductive layer is formed, and which is provided between the power device and the second conductive layer so as to face the second conductive layer.

2. The built-in substrate according to claim 1, wherein when the power device and the third conductive layer are viewed along the stacking direction, a mounting region of the power device is included in the conductor pattern.

3. The built-in substrate according to claim 2, wherein the power device and the conductor pattern are electrically connected through a via provided over an entire mounting region of the power device.

4. The built-in substrate according to any one of claims 1 to 3, wherein the first surface is a mounting surface on one end side in the stacking direction,
a plurality of electrodes electrically connected to each of a battery that supplies power to the power device and a load energized via the power device are provided on the first surface, and
the plurality of electrodes are electrically connected to the conductor pattern.

5. The built-in substrate according to any one of claims 1 to 3, wherein, among the plurality of the insulating layers, an insulating layer between the second conductive layer and the third conductive layer is formed using a material having a higher thermal conductivity than other insulating layers.
